# EUROPEAN PATENT APPLICATION

(11) **EP 0 964 557 A1**
(43) Date of publication of application: **15.12.1999**
(21) Application number: 99304097.1
(22) Date of filing: 26.05.1999
(51) Int. Cl.: H04L 25/06, H03D 3/00

(54) **Receiver DC offset compensation**

(30) Priority: 12.06.1998 US 96900
(71) Applicant: LUCENT TECHNOLOGIES INC., Murray Hill, New Jersey 07974-0636 (US)
(72) Inventor: Heckner, Gerald, Munich 80333 (DE); Kohlschmidt, Peter, 85435 Erding (DE); Lopata, Douglas D., Boyertown, Pennsylvania 19512 (US)
(74) Representative: Buckley, Christopher Simon Thirsk

(57) **Abstract**

In a receiver, e.g. for GSM, dc offset in the baseband signal output of a mixer (3) is initially estimated by closing switches (12 and 13) low pass filtering (in 14) the baseband signal to produce an estimate of the dc offset, and storing the estimate in a register (16). Switches (12 and 13) are then opened. The stored estimate is subtracted from the baseband signal in a summing amplifier (5). Residual dc offset remaining, or arising later, in the baseband signal is estimated by a residual dc offset estimator (8), and the estimate is stored in a register (9). The estimates stored in registers (9 and 16) are summed in a summer (10) prior to subtraction from the baseband signal in amplifier (5) to produce a baseband signal substantially free of dc offset enabling both the full dynamic range of A/D converter (7) to be used, and satisfactory operation of demodulator (18).

## Description

### Technical Field

This invention relates to receivers, and to methods of dc offset compensation.

### Background of the Invention

In a radio receiver where an incoming signal and a local oscillator signal are mixed in a mixer to produce a baseband signal, the baseband signal will usually, and undesirably, include a dc offset component which is dependent on a number of factors such as the particular circuitry employed, temperature, and circuit gain. The dc offset arises from the local oscillator signal leaking through the mixer and mixing with itself, and from the incoming signal leaking through the mixer and mixing with itself. Dc coupled baseband amplifiers, if present, may add to the unwanted dc offset. Where the receiver includes an A/D converter fed by the baseband signal, e.g. in a Time Division Multiple Access (TDMA) receiver, the circuit gain is normally variable so as to achieve perfect excitation in the A/D converter. However, dc offset in the baseband signal reduces the useable dynamic range of the converter, and degrades the performance of a subsequent digital receiver demodulator.

In a typical TDMA receiver the dc offset is measured regularly during receive gaps, and stored as a charge on a capacitor. It is then subtracted from the baseband signal. The receiver is designed so that, although in fact the stored charge leaks away, the dc offset can be assumed constant during one timeslot. This technique will be more fully described later.

In newer TDMA systems, such as GSM, transmission and reception over multiple timeslots is possible. and it is not therefore possible to measure the dc offset regularly during receive gaps. The problem of dc offset compensation also arises in CDMA systems using baseband sampling where continuous reception over a period of time is a system requirement. In the known technique described above, the stored charge leaks away, and, because the dc offset may vary over a period of time, due for example to changes in temperature and circuit gain, the known technique is not satisfactory for application in, for example, a GSM receiver, where its use would lead to a degradation in performance.

### Summary of the Invention

According to one aspect of this invention there is provided a receiver comprising a local oscillator; a mixer for mixing an incoming signal and output from the local oscillator to produce a baseband signal; a dc offset estimator for providing an estimate of the dc offset in the baseband signal in the absence of the incoming signal to the mixer; a first register for storing the estimated dc offset; a subtraction circuit for subtracting the stored estimate from the baseband signal; and a residual dc offset estimator for estimating residual dc offset in the baseband signal, for subtraction from the baseband signal by the subtraction circuit.

In one embodiment the first register is a digital register; and the dc offset estimator comprises a low pass filter for filtering the baseband signal to produce an estimate of the dc offset, and an A/D converter for converting the estimate to digital form for storage in the first register.

In another embodiment the first register is a digital register; and the dc offset estimator comprises means for producing in digital form a series of successive approximations of the dc offset until the dc offset is substantially estimated, and for storing the dc offset in the first register.

There may be provided a second register for storing the estimated residual dc offset. There may be provided a summer for summing the stored dc offset estimate and the stored residual dc offset estimate; wherein the subtraction circuit comprises a subtractor for subtracting the summed estimates from the baseband signal. The subtractor may be a baseband amplifier. The second register may be a digital register, and there may be provided a D/A converter for converting the summed estimates to analog form before application to the subtractor.

There may be provided a summer having an output which feeds the input of the second register, and inputs which are fed. respectively. by output of the second register and the residual dc offset estimate from the residual dc offset estimator. thereby to update the estimate stored in the second register.

Output from the residual dc offset estimator may be fed to the second register via a delay element, and directly to one input of a subtractor having another input fed by output from the subtraction circuit.

The said one embodiment of the receiver may comprise an A/D converter for receiving output from the subtraction circuit; wherein the residual dc offset estimator is fed by output from the A/D converter.

The said other embodiment of the receiver may comprise an A/D converter for receiving output from the subtraction circuit; wherein the dc offset estimator and the residual dc offset estimator are fed by output from the A/D converter.

There may be provided a switch for isolating the input and the output of the dc offset estimator after estimation of the dc offset.

According to another aspect of this invention there is provided a method of compensating for dc offset in the baseband signal output of a mixer fed by an incoming signal and a local oscillator signal, comprising: estimating the dc in the baseband signal in the absence of the incoming signal to the mixer; storing the estimated dc offset in a register; estimating residual dc offset in the baseband signal; and subtracting the stored estimate and the residual dc offset from the baseband signal.

### Brief Description of the Drawings

The invention will now be described by way of example with reference to the accompanying drawings, in which:
FIG. 1 is a schematic diagram of part of a TDMA receiver employing a known dc offset compensation technique:
FIG.2 shows the relationship between FIGS.2A and 2B which are a schematic diagram of part of a receiver embodying the invention, and the relationship between FIGS. 2C and 2D which are a schematic diagram of part of another receiver embodying the invention; and

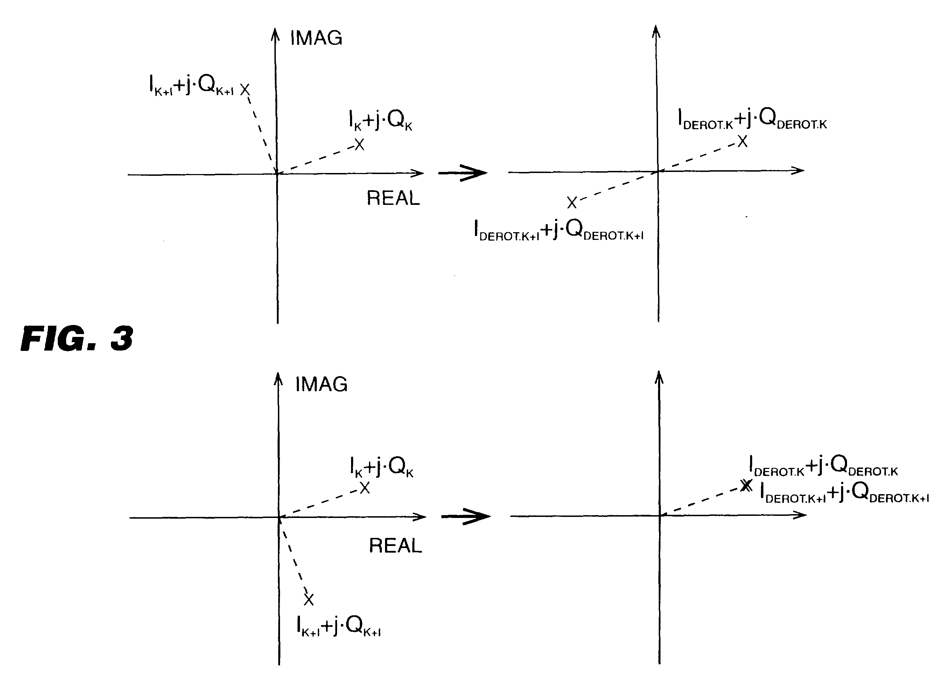

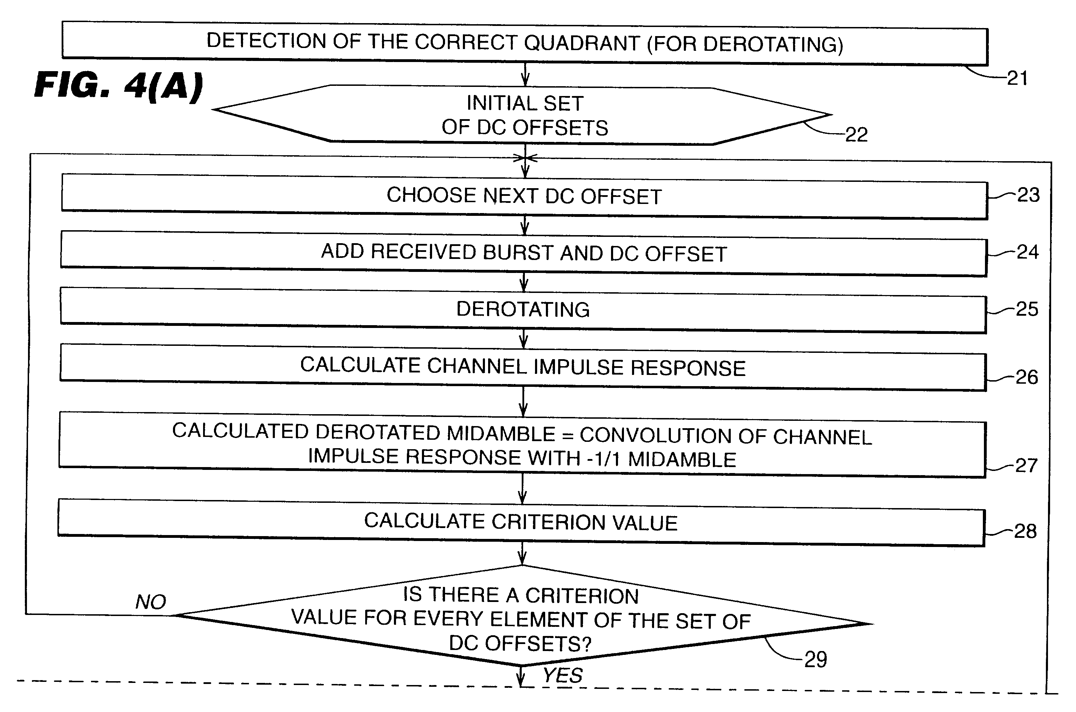

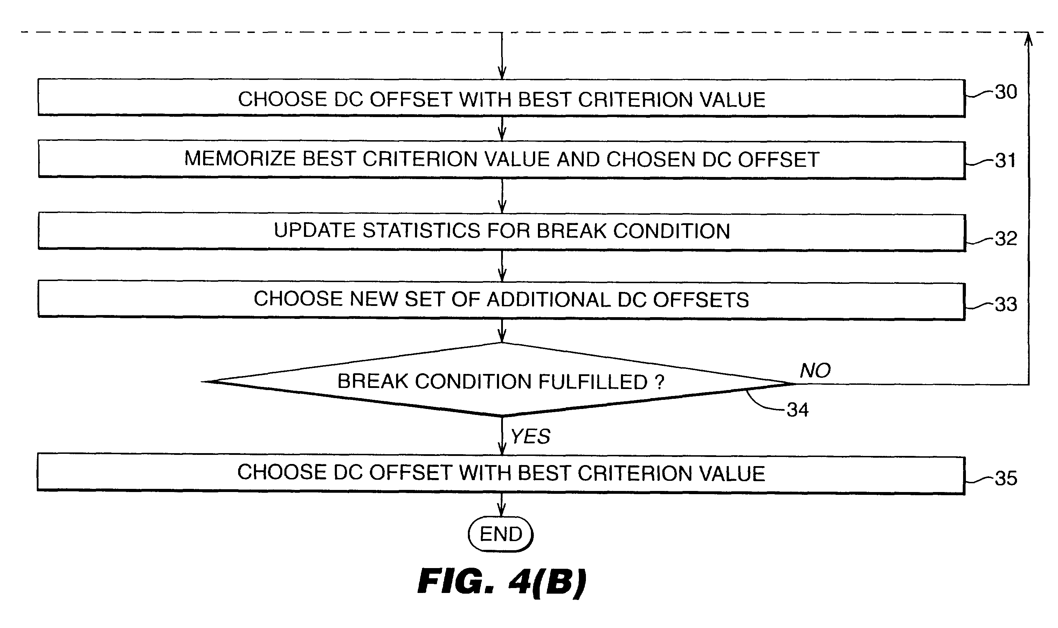

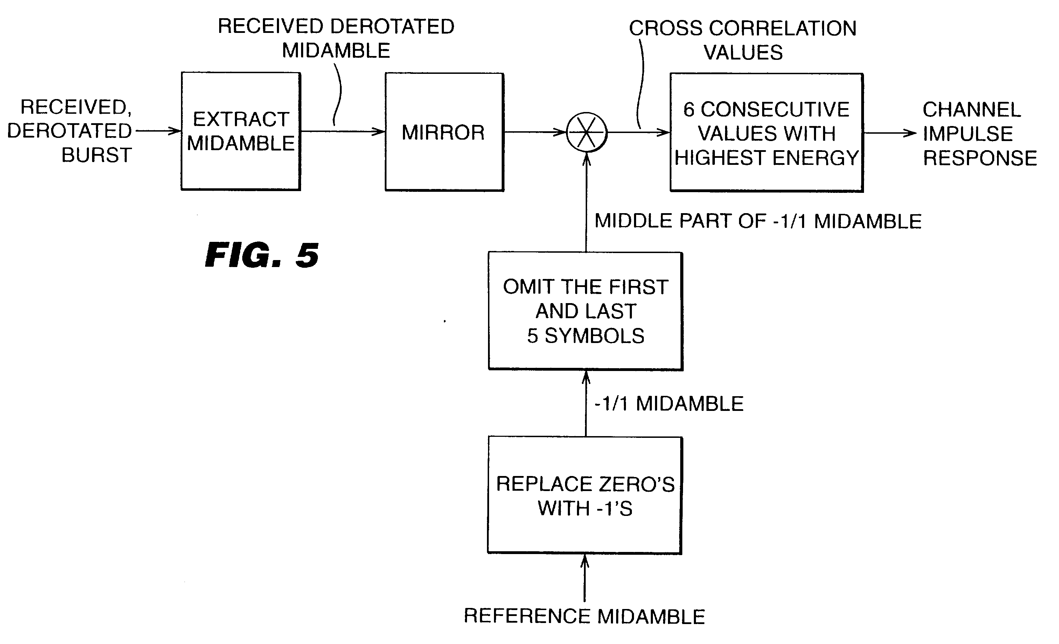

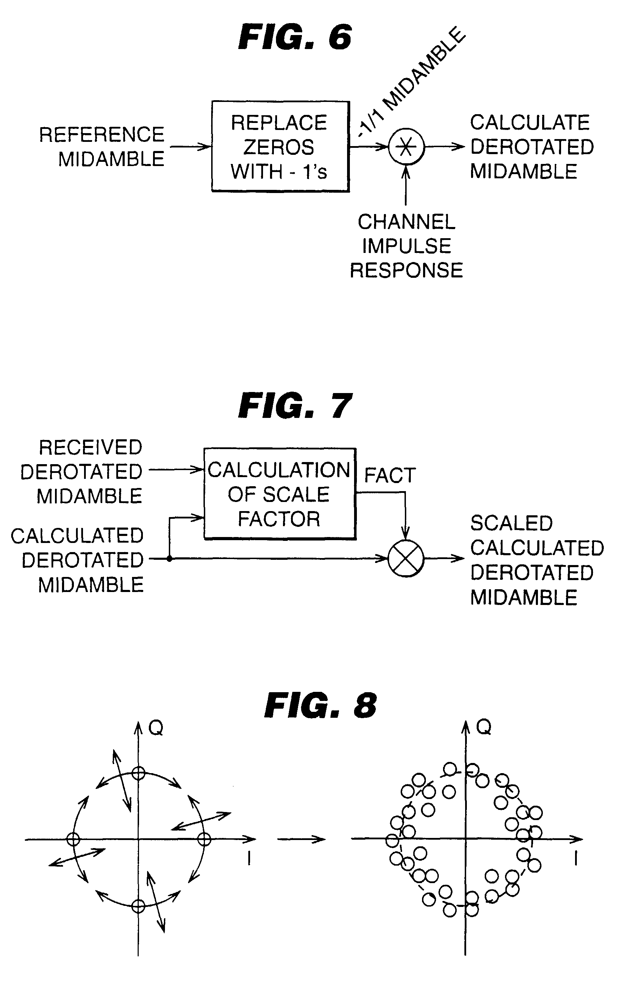

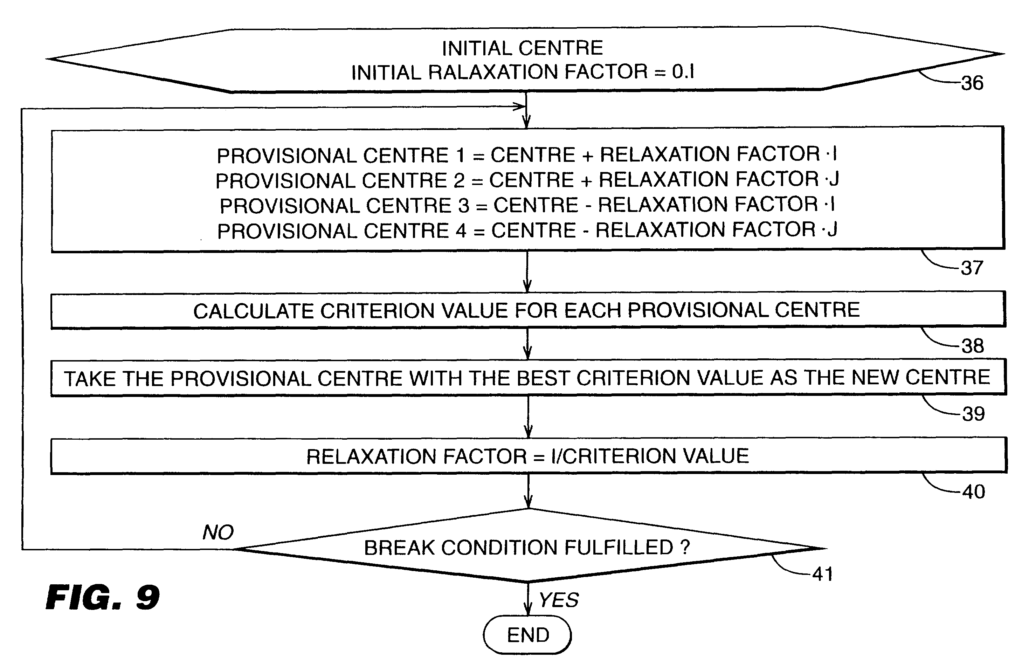

FIGS. 3 to 9 are various flow and other diagrams referred to in an Appendix hereto describing three ways of estimating dc offset, FIG.4 showing the relationship between FIGS. 4A and 4B.

### Detailed Description

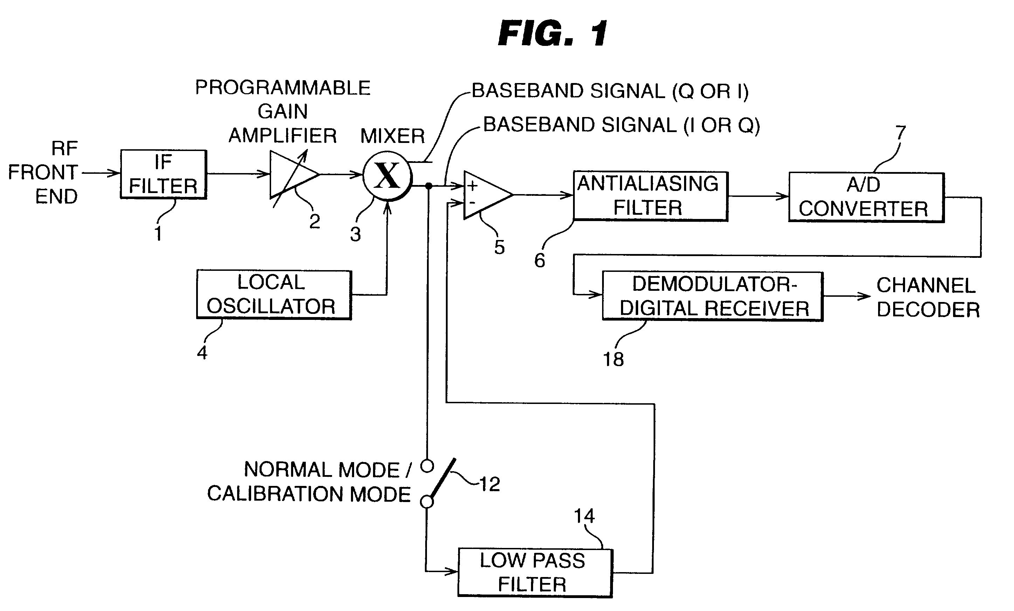

Referring now to Fig. 1, a signal from the receiver front end (not shown) is filtered in an IF filter 1, amplified in a programmable gain amplifier 2, and applied as one input to a mixer 3 whose other input, supplied by a local oscillator 4, is at a frequency whereby the mixer output is at baseband. Normally, the mixer output comprises both I and Q components, but for the sake of clarity only one component, and the associated circuitry, will be considered.

Due to the action of the mixer, the baseband output may contain a dc offset, the magnitude of which may be dependent on factors such as temperature, and the gain of amplifier 2. The baseband output is applied to the positive input of a summing amplifier 5 whose output is fed to an antialiasing filter 6 which in turn feeds an A/D converter 7. The output of A/D converter 7 is fed to a demodulator or digital receiver 18. Any dc offset in the baseband signal reduces the useable dynamic range of the A/D converter 7, and degrades the performance of the demodulator 18 and any subsequent channel decoder (not shown). Summing amplifier 5 itself may introduce an additional dc offset to the baseband signal.

In order to compensate for the dc offset, the dc offset is estimated regularly, and a signal representative of it is applied to the negative input of summing amplifier 5 so as to compensate for the dc offset prior to the A/D converter 7.

Estimation of the d.c. offset is usually done during receive gaps as follows. The input to the amplifier 2 is grounded so as to shunt any signal from the RF front end to ground. A normally open switch 12 is closed, i.e. it is switched to the calibration mode, and a low pass filter 14 filters out the dc offset in the baseband signal. The charge acquired on a capacitor in filter 14 is an estimate of the dc offset and is applied to the negative input of amplifier 5 which subtracts the estimate from the baseband signal. After each estimation of the dc offset, the input to amplifier 2 is ungrounded, switch 12 is opened, and normal reception is resumed.

As noted earlier, where mixer 3 provides both I and Q output components, a further summing amplifier 5, filter 6, A/D converter 7, switch 12 and low pass filter 14, none of which is shown, are required to process the other component.

This solution suffers from the defect that the charge on the capacitor leaks away, and thus the dc offset estimate applied to amplifier 5 varies over time. Furthermore, any dc offset due to mixing of the IF signal with itself in mixer 3 will not be accounted for because the input to amplifier 2 is grounded during dc offset estimation.

In newer TDMA systems, such as GSM, where reception and transmission over multiple timeslots is possible, regular estimation of the dc offset during receive gaps is not possible, and because of this and because the stored charge leaks away, and because the dc offset is gain and temperature dependent, and thus may vary over time, dc offset compensation as described above is unsatisfactory. It is also not suitable in CDMA systems using baseband sampling where continuous reception over a period of time is a system requirement.

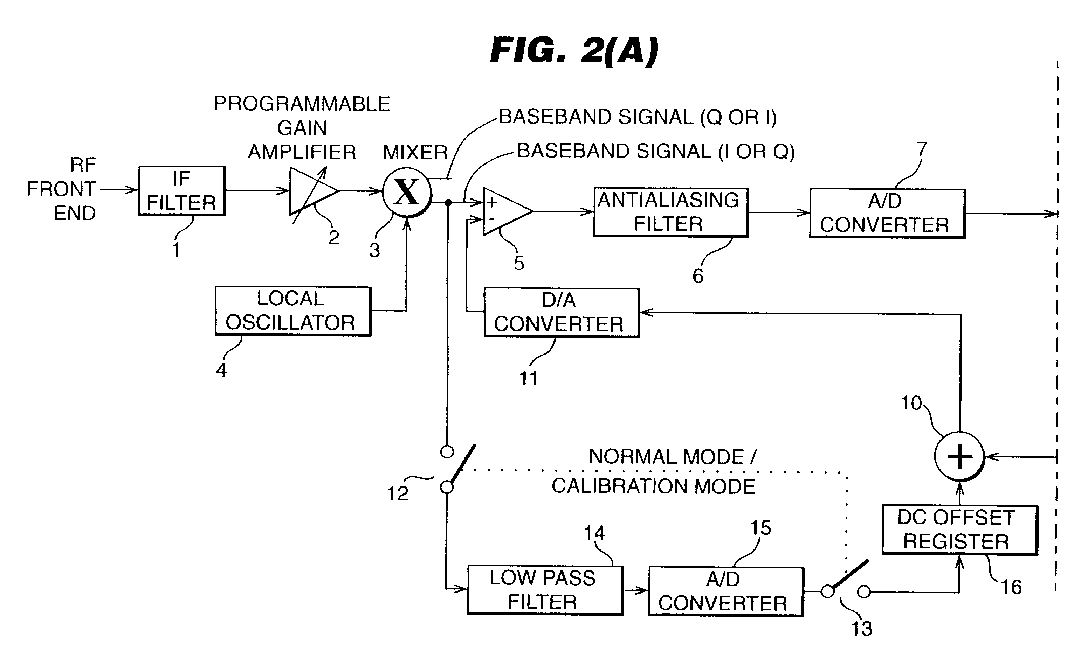

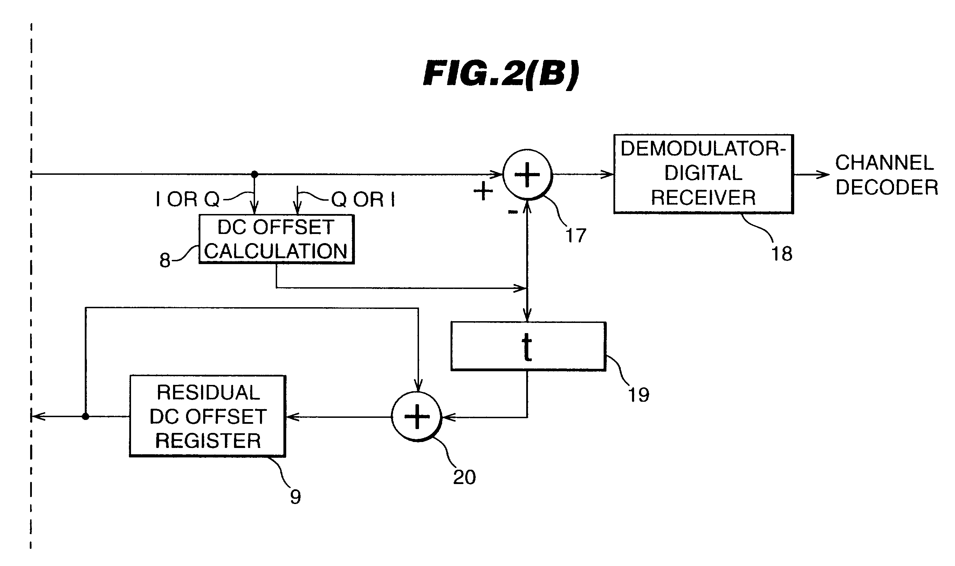

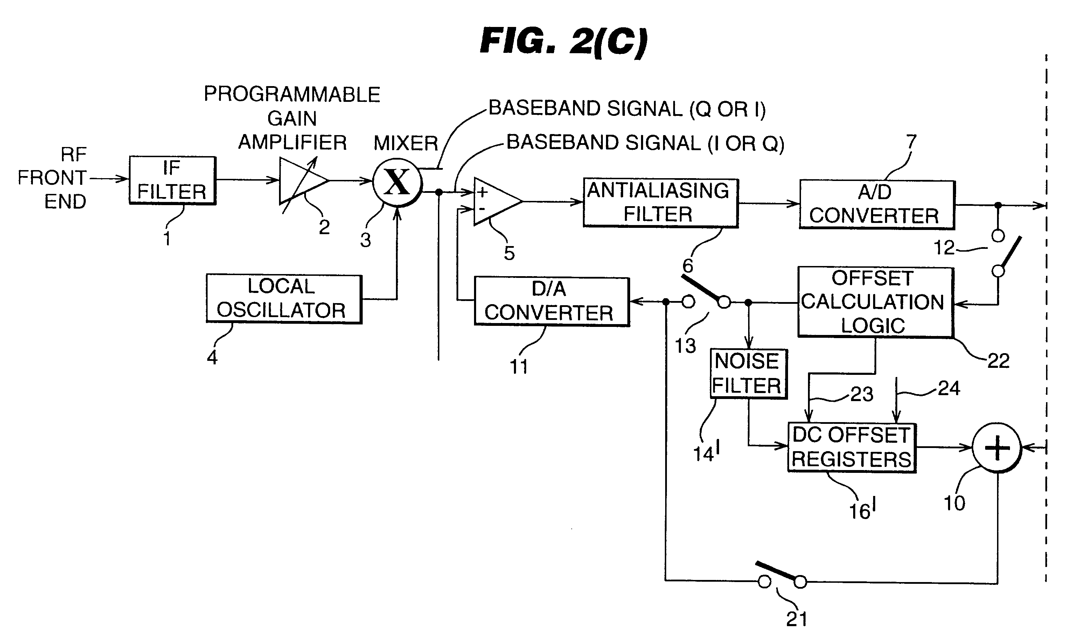

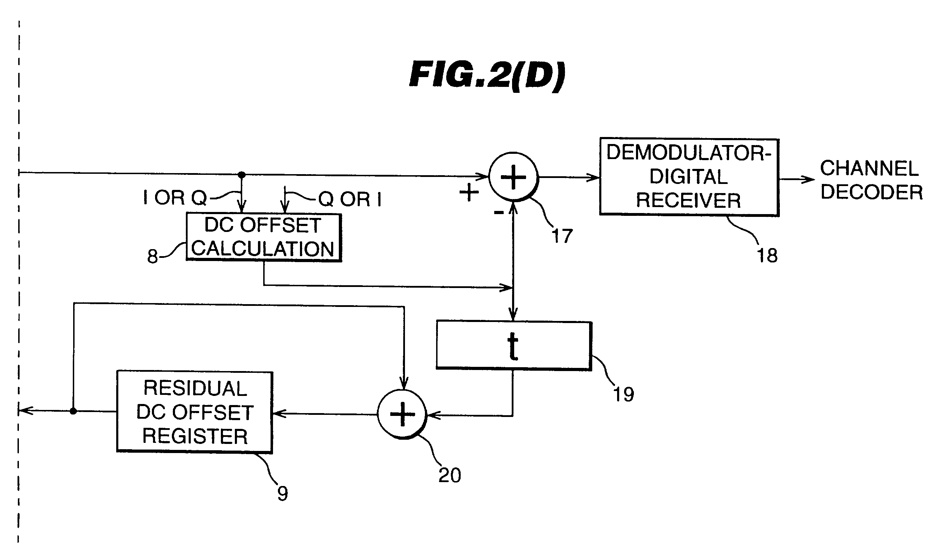

Referring now to Figs. 2A and 2B, the operation of filter 1, amplifier 2, mixer 3 and local oscillator 4 are as previously described with reference to Fig. 1. In Figs. 2A and 2B, however, dc offset compensation is effected as follows.

An initial dc offset estimate is required because the dc offset in the baseband signal output of mixer 3 may be a significant, or even the major, component of the baseband signal. A dc offset of significant magnitude may swamp the A/D converter 7 and cause it to give an erroneous output, with a consequent deleterious effect on subsequent circuit elements.

Initial dc offset estimation is effected by grounding the input to amplifier 2. Switches 12 and 13 are closed, i.e. switched to the calibration mode, and a low pass filter 14 filters out the dc offset in the baseband signal. The charge acquired on a capacitor in filter 14 is an estimate of the dc offset and is converted to digital form by an A/D converter 15 and stored in a dc offset register 16. The input to amplifier 2 is then ungrounded and switches 12 and 13 are opened, i.e. switched to the normal mode. The estimate stored in register 16 is applied via summer 10, of which more later, to a D/A converter 11 which provides an analog version of the stored dc offset estimate to the negative input of summing amplifier 5, which in turn subtracts the dc offset estimate from the baseband signal. The output of amplifier 5 is provided, via an antialising filter 6, to an A/D converter 7 whose output feeds a demodulator or digital receiver 18 and channel decoder (not shown). Removal of the dc offset from the baseband signal enables the full dynamic range of the A/D converter 7 to be used, and avoids degrading the performance of the demodulator 18. Because the dc offset estimate is stored in register 16, subsequent charge leakage in the capacitor in filter 14 is of no effect.

As noted earlier however, it is not feasible to estimate the dc offset regularly in receive gaps in newer TDMA systems, such as GSM, where multiple timeslot operation is contemplated, and thus any residual dc offset arising, or remaining, after the initial estimation will affect the performance of A/D converter 7 and demodulator 18. Residual dc offset in the baseband signal, e.g. due to changes in gain or temperature, is estimated by a residual dc offset estimator 8, and the estimate is stored, after a time delay in delay 19, in a residual dc offset register 9. Estimator 8 may be a processor adapted to operate under the control of a suitable algorithm to produce an estimate of the residual dc offset. Three ways of estimating the residual dc offset are given by way of example in the Appendix hereto. It will be noted that estimator 8 requires both I and Q inputs to perform the exemplary algorithms.

The estimate stored in register 9 is summed in summer 10 with the estimate stored in register 16, and the sum is converted to analog form in D/A converter 11 whose output is subtracted from the baseband signal in amplifier 5 to provide an output which is substantially free of dc offset. A summer 20 is fed with output from register 9 and output from time delay 19 so as to update register 9 as changes in the residual dc offset occur. The output of estimator 8 also feeds a subtractor 17 so that changes in the residual dc offset can be subtracted instantaneously from the signal fed to the demodulator 18. The delay provided by time delay 19 is chosen so as to prevent the residual dc offset estimate produced by estimator 8 from being subtracted twice over, once in amplifier 5, and again at the output of A/D converter 7.

As noted earlier, estimator 8 is fed with both I and Q input components. For the sake of clarity Figs. 2A and 2B show only the circuit elements for processing one of these components; for processing the other component a further set of components 5 to 7, 9 to 17 and 19 is required.

It will thus be understood that the demodulator 18 will always receive a signal substantially free of dc offset, and the useable dynamic range of A/D converter 7 will be maximised.

When switches 12 and 13 are open. i.e. in the normal mode, power saving may be achieved by de-energising filter 14 and A/D converter 15. Further power savings may be made if there is no change in the residual dc offset, or if any changes are slow and small, by estimating the residual dc offset less frequently.

Variations will, of course, occur to those skilled in the art. For example, switch 12, shown connected to the output of mixer 3, could instead be connected to the output of summing amplifier 5. The initial dc offset estimation would then take into account any dc offset introduced by amplifier 5 itself. Furthermore, instead of summing the outputs of registers 9 and 16. the contents of these registers could be individually subtracted from the baseband signal, e.g. by summing amplifier 5 subtracting only the dc offset estimate, and another subtractor fed with output from amplifier 5 for subtracting the residual dc offset estimate after any necessary D/A conversion.

Another receiver embodying the invention will now be desribed with reference to FIGS. 2C and 2D in which components bearing the same reference signs as those in FIGS. 2A and 2B perform corresponding functions as already described. The main difference between the receiver of FIGS. 2A and 2B and the receiver of FIGS. 2C and 2D lies in the manner in which the initial DC offset is estimated.

To estimate the initial DC offset, switches 12 and 13 are closed and switch 21 is opened, the input to amplifier 2 being grounded as before. Offset calculation logic 22 includes a comparator (not shown) which is fed with output from the A/D converter 7 and which provides a signal representative of whether the DC offset in the A/D converter's output is positive. negative, or zero. Offset calculation logic 22 also includes logic circuitry (not shown) which provides to D/A converter 11 an offset compensation signal dependent upon whether the comparator output represents a positive or negative DC offset. The output of D/A converter 11 is subtracted in amplifier 5 from the baseband signal, and the output of A/D converter 7 is again examined by the comparator in offset calculation logic 22 to repeat the process just described. The process is repeated until, by a series of successive approximations, the compensation signal provided to the D/A converter 11 is such as to substantially cancel the DC offset in the baseband signal. At this point, the comparator in offset calculation logic 22 provides a signal representative of zero DC offset and the process of successive approximations is stopped. Switches 12 and 13 are opened and a digital representation of the DC offset at the output of offset calculation logic 22 is low-pass filtered in a noise filter 14' and stored in DC offset registers 16' in response to a latch signal on lead 23 from offset calculation logic 22. Logic circuitry suitable for performing the functions of offset calculation logic 22 will be well-known to those skilled in the art, and will not be described further.

After the initial DC offset estimation is complete, switch 21 is closed, and subsequent operation is as already described with reference to FIGS. 2A and 2B. Thus, any residual DC offset arising. or remaining, after the initial estimation is estimated by residual DC offset estimator 8, and the estimate is stored, after a time delay in delay 19, in residual DC offset register 9. The estimate stored in register 9 is summed in summer 10 with the estimate stored in registers 16', and the sum is converted to analog form in D/A converter 11 prior to subtraction from the baseband signal in amplifier 5 to provide an output which is substantially free of DC offset.

As noted earlier, the DC offset is dependent upon the gain of programmable gain amplifier 2, and thus may vary for different gain settings. By performing for each of the gain settings of amplifier 2 an initial DC offset estimation in the manner described. it is possible to store a corresponding DC offset estimate in DC offset registers 16'. Thus, DC offset registers 16' effectively constitute a form of look-up table which provides to summer 10 the DC offset estimate appropriate to the gain setting of amplifier 2 in accordance with a "gain select" signal on lead 24. Storing a plurality of DC offset estimates avoids the need to perform an initial DC offset estimation process each time the gain of amplifier 2 is changed.

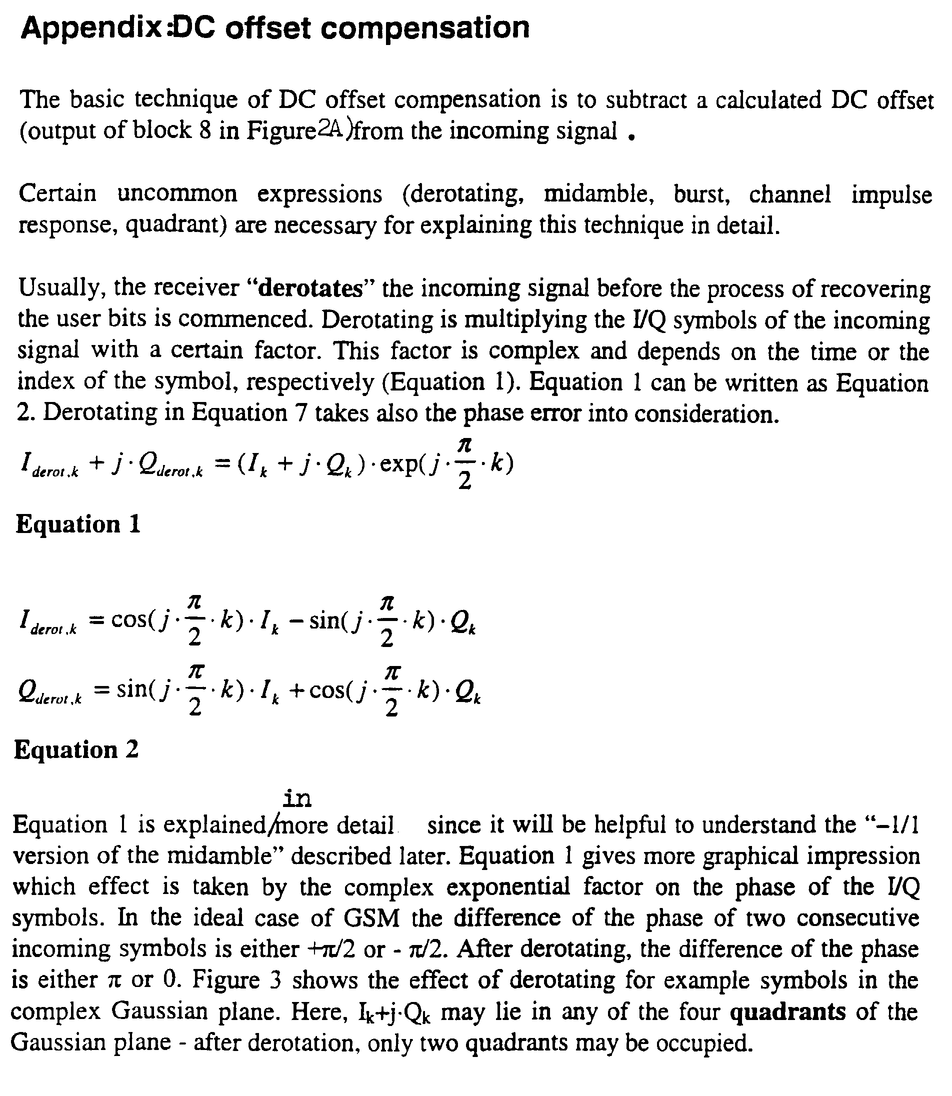

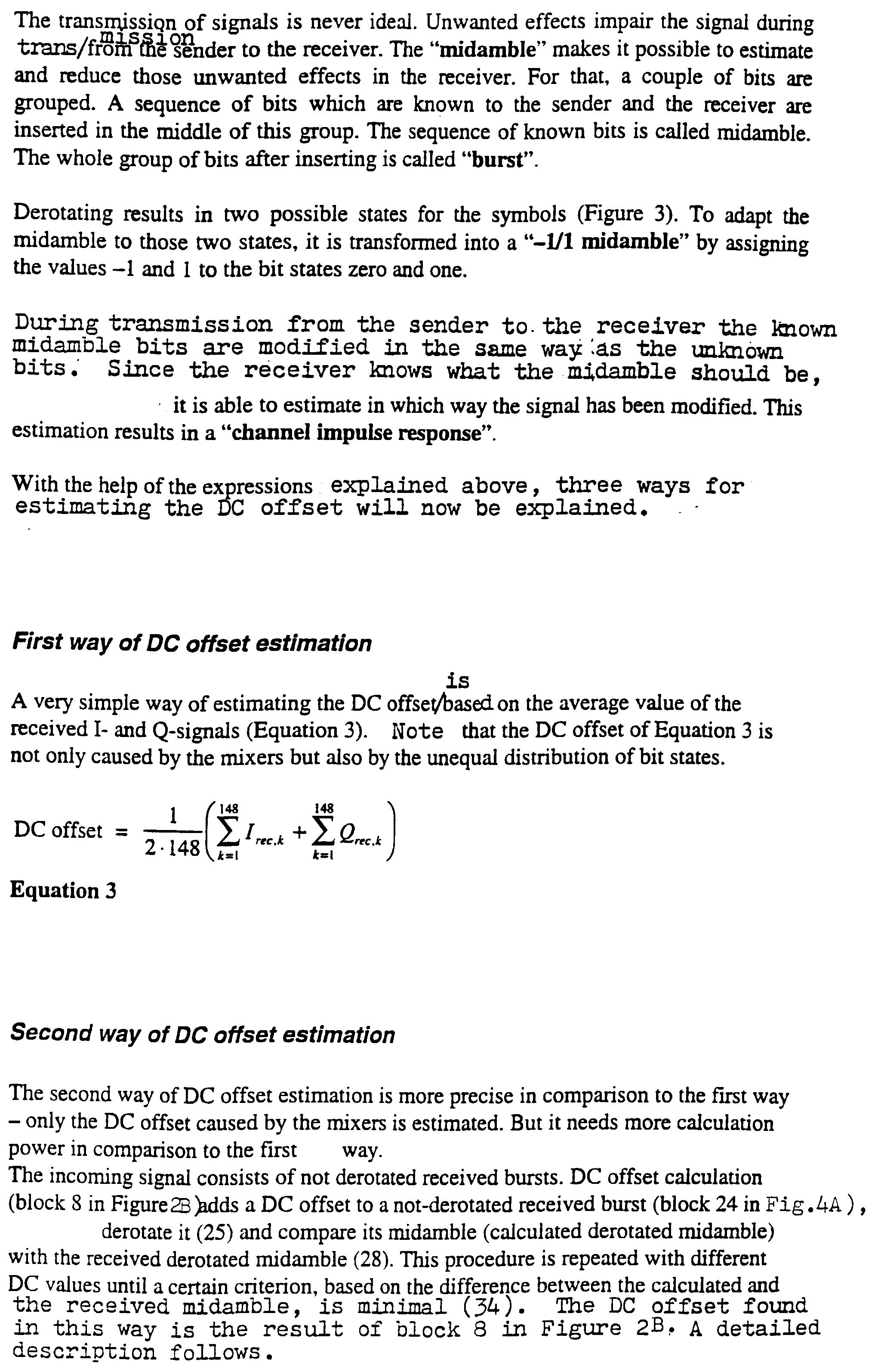

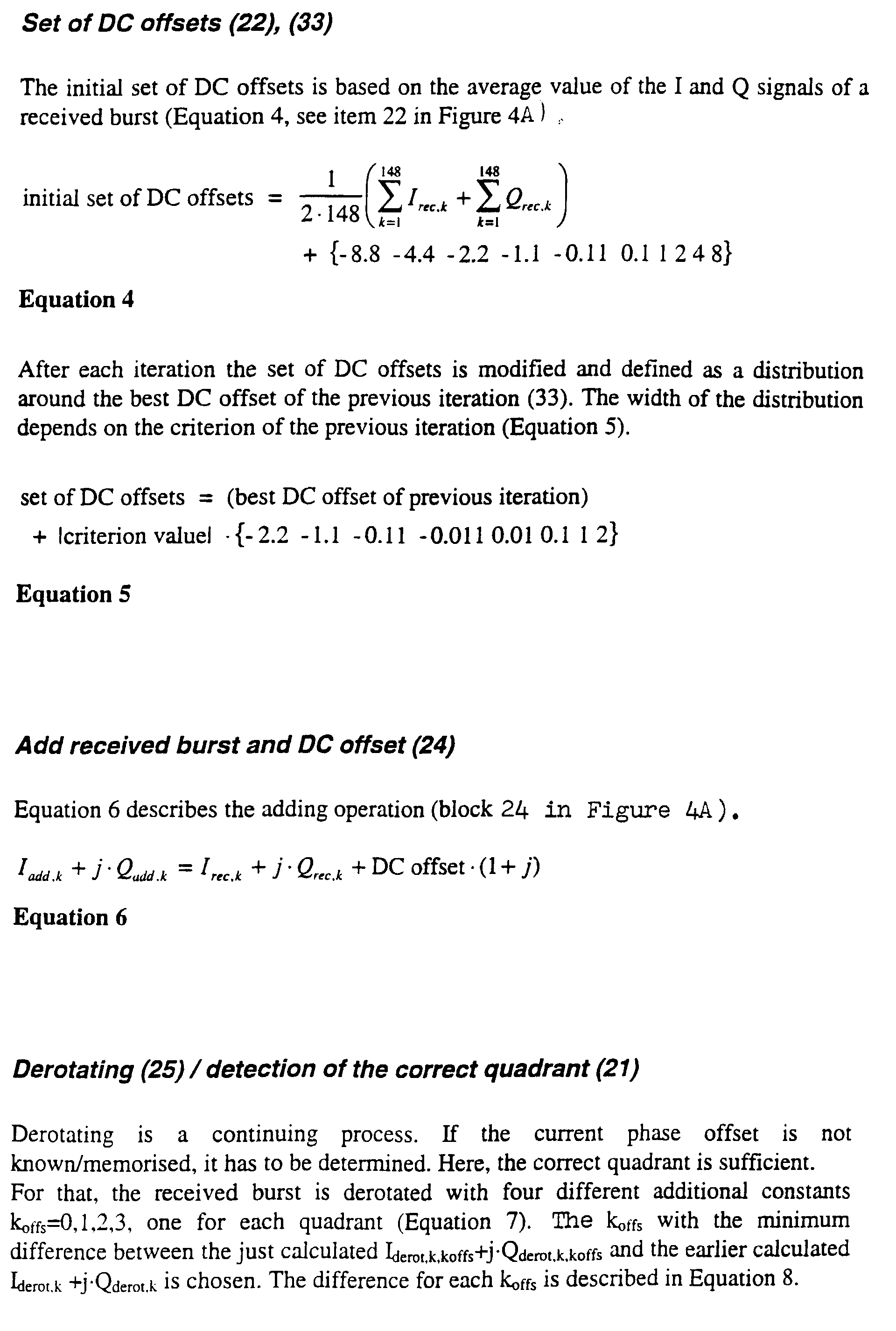

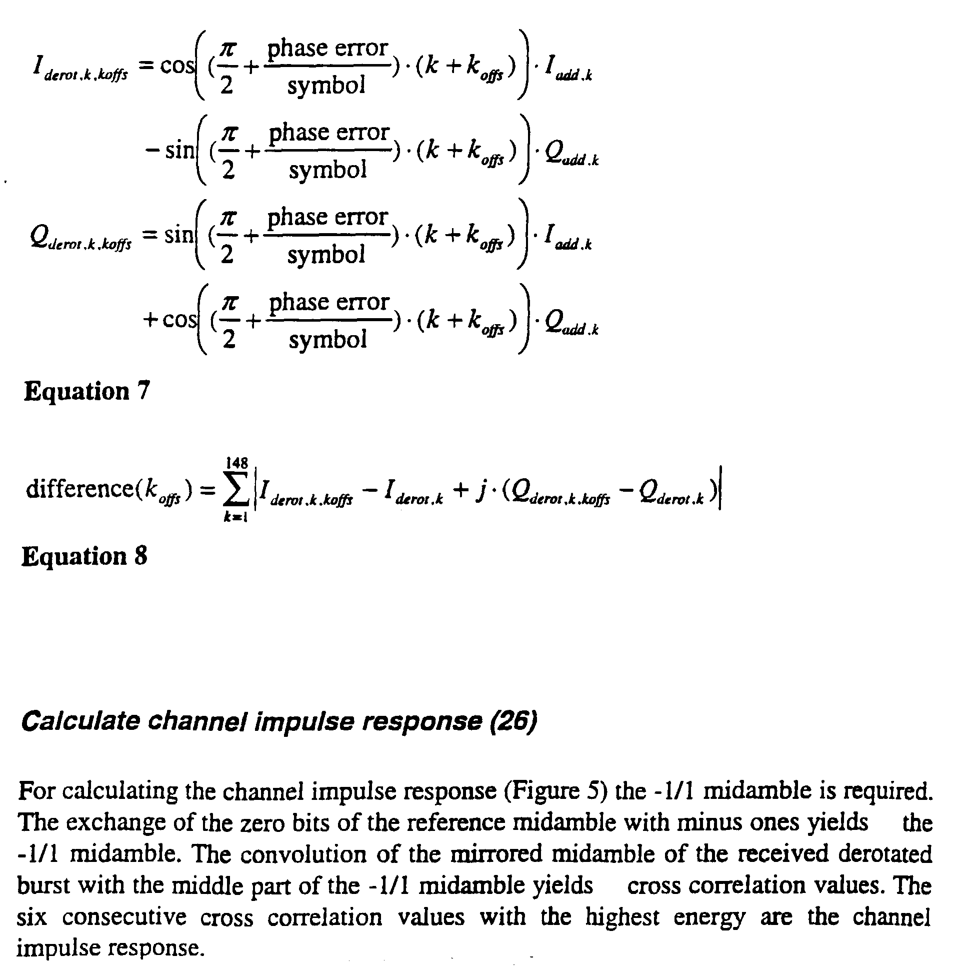

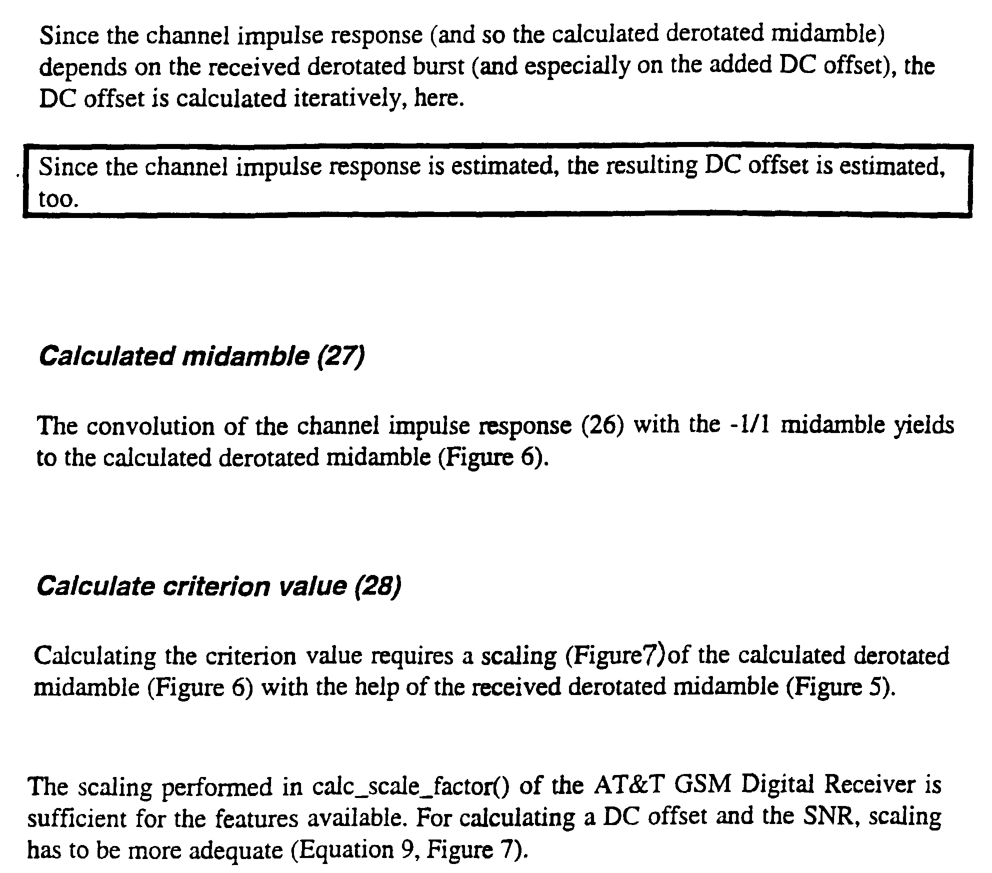

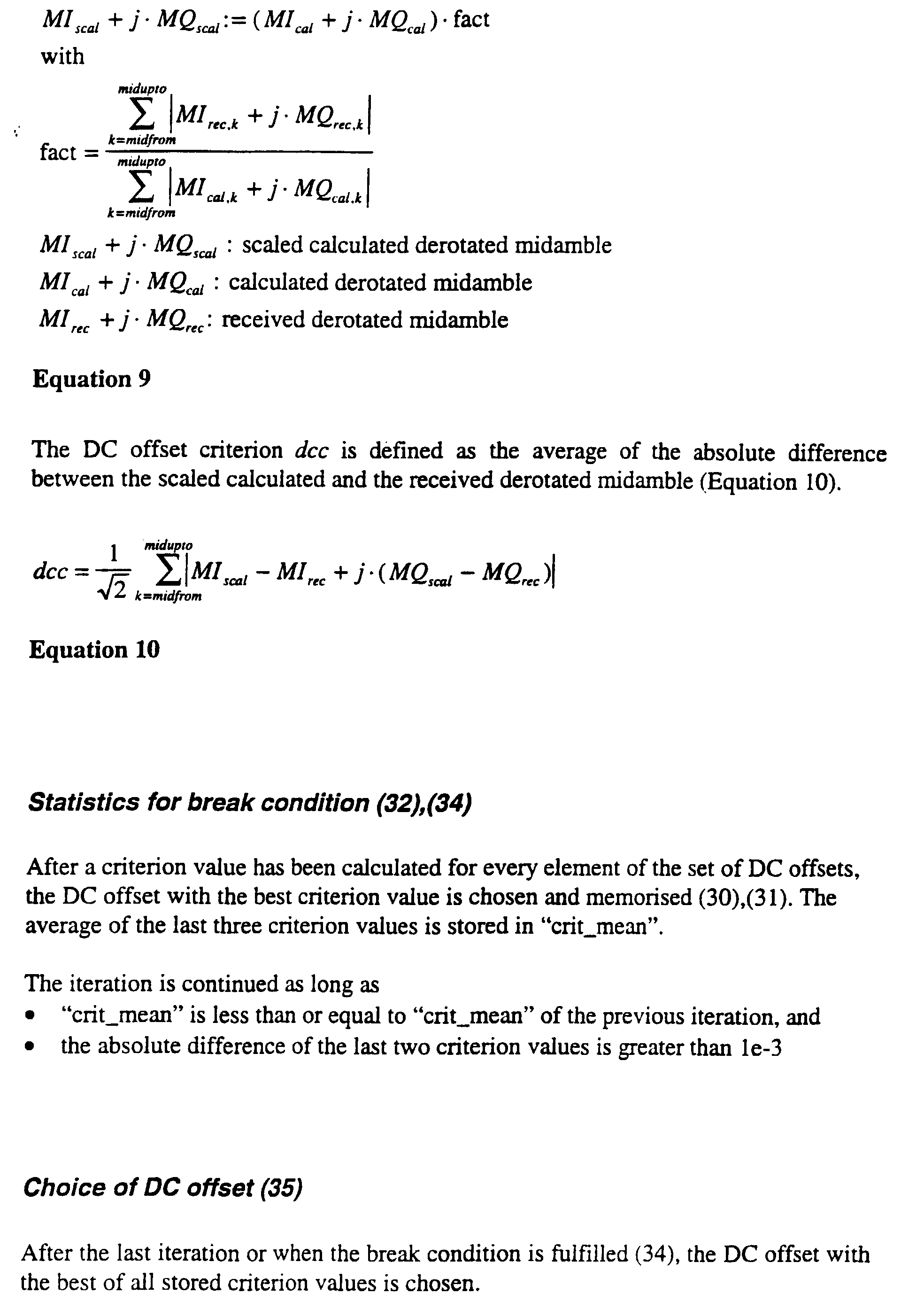

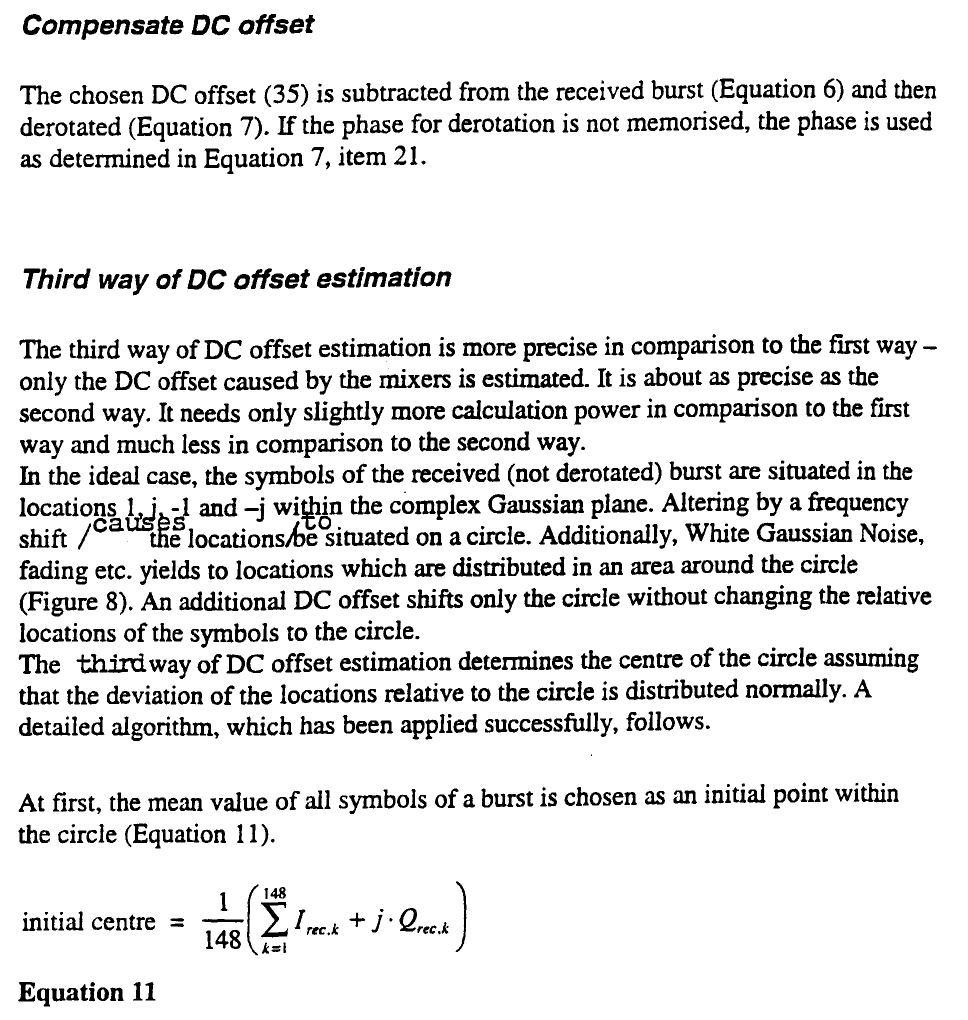

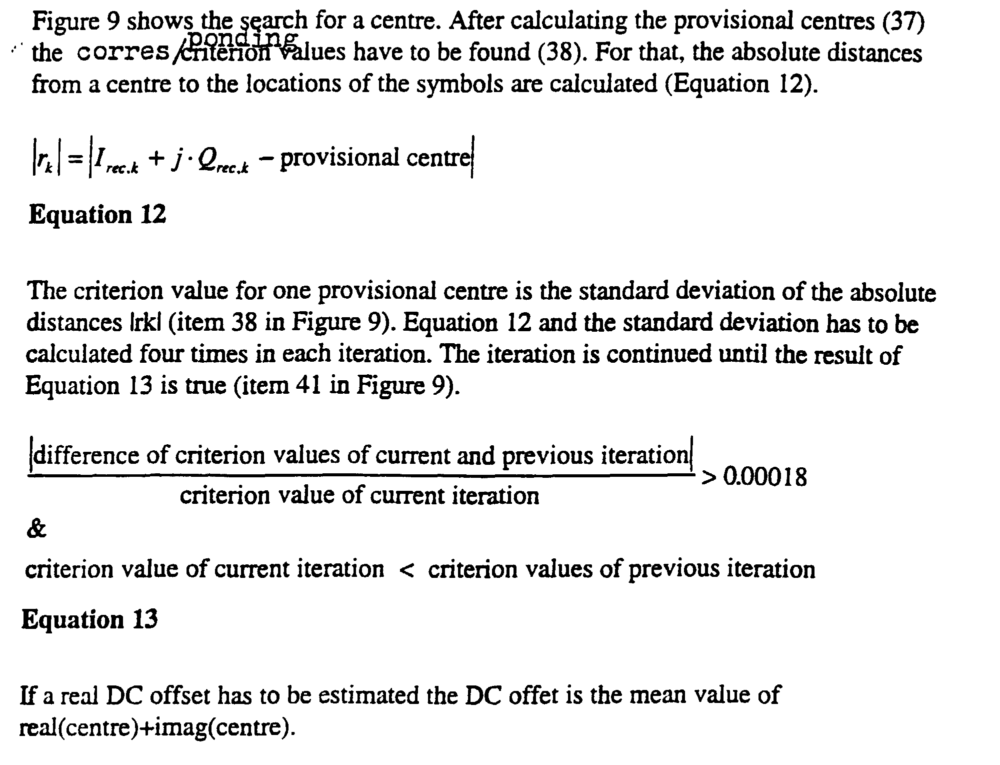

## Claims

1. A receiver comprising:
a local oscillator;
a mixer for mixing an incoming signal and output from the local oscillator to produce a baseband signal;
a dc offset estimator for providing an estimate of the dc offset in the baseband signal in the absence of the incoming signal to the mixer;
a first register for storing the estimated dc offset;
a subtraction circuit for subtracting the stored estimate from the baseband signal; and
a residual dc offset estimator for estimating residual dc offset in the baseband signal. for subtraction from the baseband signal by the subtraction circuit.

2. A receiver as claimed in claim 1 wherein:
the first register is a digital register; and
the dc offset estimator comprises a low pass filter for filtering the baseband signal to produce an estimate of the dc offset, and an A/D converter for converting the estimate to digital form for storage in the first register.

3. A receiver as claimed in claim 1 wherein:
the first register is a digital register; and
the dc offset estimator comprises means for producing in digital form a series of successive approximations of the dc offset until the dc offset is substantially estimated. and for storing the estimated dc offset in the first register.

4. A receiver as claimed in claim 1,2 or 3 comprising a second register for storing the estimated residual dc offset.

5. A receiver as claimed in claim 4 comprising a summer for summing the stored dc offset estimate and the stored residual dc offset estimate;
wherein the subtraction circuit comprises a subtractor for subtracting the summed estimates from the baseband signal.

6. A receiver as claimed in claim 5 wherein the subtractor is a baseband amplifier.

7. A receiver as claimed in claim 5 or 6 wherein:
the second register is a digital register;
and there is provided a D/A converter for converting the summed estimates to analog form before application to the subtractor.

8. A receiver as claimed in claim 4,5,6 or 7 comprising a summer having an output which feeds the input of the second register, and inputs which are fed, respectively, by output of the second register and the residual dc offset estimate from the residual dc offset estimator, thereby to update the estimate stored in the second register.

9. A receiver as claimed in any one of claims 4 to 8 wherein output from the residual dc offset estimator is fed to the second register via a delay element, and directly to one input of a subtractor having another input fed by output from the subtraction circuit.

10. A receiver as claimed in any one of claims 1 to 9 comprising an A/D converter for receiving output from the subtraction circuit:
wherein the residual dc offset estimator is fed by output from the A/D converter.

11. A receiver as claimed in any one of claims 1 and 3 to 9, comprising an A/D converter for receiving output from the subtraction circuit;
wherein the dc offset estimator and the residual dc offset estimator are fed by output from the A/D converter.

12. A receiver as claimed in any preceding claim comprising a switch for isolating the input and the output of the dc offset estimator after estimation of the dc offset.

13. A method of compensating for dc offset in the baseband signal output of a mixer fed by an incoming signal and a local oscillator signal, comprising:
estimating the dc in the baseband signal in the absence of the incoming signal to the mixer;
storing the estimated dc offset in a register;
estimating residual dc offset in the baseband signal; and
subtracting the stored estimate and the residual dc offset from the baseband signal.
